# EUROPEAN PATENT APPLICATION

(11) **EP 4 753 149 A1**
(43) Date of publication of application: **03.06.2026**
(21) Application number: 24315542.1
(22) Date of filing: 28.11.2024
(51) Int. Cl.: H03K 17/12

(54) **POWER MANAGEMENT WITH A HYBRID CIRCUIT ARCHITECTURE**

(71) Applicant: NXP USA, Inc., Austin, TX 78735 (US)
(72) Inventor: Calmes, Pierre, 31023 Toulouse (FR); Mazeaud, Thomas, 31023 Toulouse (FR); Alexander, Travis, 5656 AG Eindhoven (NL)
(74) Representative: Schmütz, Christian Klaus Johannes

(57) **Abstract**

This disclosure relates to a power module, a power converter, a method, and a computer program for supplying a target amount of power across different power ranges using a hybrid circuit architecture.

## Description

### TECHNICAL FIELD

The present disclosure relates to a power module, a power converter and a method for power management in electrical systems. Specifically, the present disclosure relates to utilization of a power controller to dynamically control different groups of power switches of a hybrid electric circuit architecture based on determined power ranges to supply a target power value.

### BACKGROUND

Power modules are often used to provide power that is supplied to various types of electric loads, such as vehicles or parts of vehicles including, for example, onboard systems, electric motors or any other electric devices. In the case of mobile setups, such as vehicles, power modules are required to convert the energy stored in energy sources, such as batteries, into one or more demanded electric currents and/or voltages. One or more such power modules may be part of power converters used for such purposes. In mobile use cases, such modules operate under a range of different ambient or environmental conditions as well as a range of different power levels that may dynamically change based on, for example, geographical location and/or current power demand.

### SUMMARY

According to a first aspect of the present disclosure there is provided a power module comprising a first group of power switches; a second group of power switches different from the first group of power switches; and a power controller electrically connected to the first group and the second group of power switches. The power controller is configured to control the power switches of the power module, and is further configured to: obtain a target power value, the target power value corresponding to an amount of power that is to be supplied by the power module; determine if the target power value falls within a low, a medium or a high power range, the low power range comprising any power values below a first threshold power value, the medium power range comprising any power values between the first threshold power value and a second threshold power value and the high power range comprising any power values above the second threshold power value; control the first group of power switches if the obtained target power value falls within the low power range; control at least one of the first and the second groups of power switches if the obtained target power value falls within the medium power range; control the second group of power switches if the obtained target power value falls within the high power range.

In one or more embodiments the first group of power switches has lower switching losses than the second group of power switches.

In one or more embodiments the first group of power switches has lower conduction losses than the second group of power switches if supplying power at levels within the low power range.

In one or more embodiments the first group of power switches are one of a silicon carbide (SiC) metal oxide semiconductor field effect transistor (MOSFET) or a gallium nitride (GaN) MOSFET .

In one or more embodiments the power switches of the second group of power switches support a higher maximum output current than the power switches of the first group of . power switches.

In one or more embodiments the power switches of the first group of power switches support a faster switching speed than the power switches of the second group of power switches.

In one or more embodiments the second group of power switches is of an insulated gate bipolar transistor (IGBT) type.

In one or more embodiments the medium power range is further divided into a lower medium power range and a higher medium power range, wherein the lower medium power range comprises any power values between the first threshold power value and an intermediate threshold power value and the higher medium power range comprises power values between the intermediate threshold power value and the second threshold power value. Further, the power controller is configured to control the first group of power switches at times that at least partially differ from times during which the second group of power switches are controlled by the power controller, if the obtained target power value falls within the lower medium or the higher medium power range.

In one or more embodiments, if the obtained target power value falls within the lower medium power range, the power controller is further configured to control the first group of power switches at a time t1 and at a time t2; and control the second group of power switches at a time t1+n and at the time t2, or at the time t1 and at a time t2-n, or at the time t1+n and at the time t2-n; wherein the time t2 is subsequent in time to the time t2-n, the time t2-n is subsequent in time to the time t1+n and the time t1+n is subsequent in time to the time t1, wherein a time offset n may be different or the same for each of the times t1+n and t2-n.

In one or more embodiments, if the obtained target power value falls within the higher medium power range, the power controller is further configured to control the first group of power switches at the time t1 and the time t1+n, or at the time t2-n and the time t2, or at each of the times t1, t1+n, t2-n and t2; and to control the second group of power switches at any time after the time t1 and at any time before the time t2.

In one or more embodiments the power controller is configured to control the power switches of the first and second groups of power switches based on a measurement using a current mirror that is integrated in at least one of the first and second groups of power switches.

In one or more embodiments the power controller is configured to obtain the target power value based on a voltage drop across a shunt resistor that is arranged in series with a current path of the power module .

According to a second aspect of the present disclosure there is provided a power converter comprising: one or more power modules according to any one of the embodiments herein and an electric interface configured for connecting the power converter to a power source and to a load.

According to a third aspect of the present disclosure there is provided a power converter comprising one or more power modules, an electric interface configured for connecting the power converter to a power source and to a load, the one or more power modules further comprising: a first group of power switches; a second group of power switches different from the first group of power switches; and a power controller electrically connected to the first group and the second group of power switches. The power controller is configured to control the power switches of the power module, and is further configured to: obtain a target power value, the target power value corresponding to an amount of power that is to be supplied by the power module; determine if the target power value falls within a low, a medium or a high power range, the low power range comprising any power values below a first threshold power value, the medium power range comprising any power values between the first threshold power value and a second threshold power value and the high power range comprising any power values above the second threshold power value; control the first group of power switches if the obtained target power value falls within the low power range; control at least one of the first and the second groups of power switches if the obtained target power value falls within the medium power range; control the second group of power switches if the obtained target power value falls within the high power range.

In one or more embodiments the first group of power switches has one or more of: lower switching losses than the second group of power switches, lower conduction losses than the second group of power switches if supplying power at levels within the low power range.

In one or more embodiments the first group of power switches is a silicon carbide (SiC) metal oxide semiconductor field effect transistor (MOSFET) type or a gallium nitride (GaN) MOSFET type.

In one or more embodiments the power switches of the first group of power switches support a faster switching speed than the power switches of the second group of power switches.

In one or more embodiments the second group of power switches support a higher maximum output current than the power switches of the first group of power switches.

In one or more embodiments, the second group of power switches is of an insulated gate bipolar transistor (IGBT) type.

According to a fourth aspect of the present disclosure, there is provided a method performed by a power controller comprising: obtaining a target power value, the target power value corresponding to an amount of power that is to be supplied by a first group of power switches and a second group of power switches different from the first group of power switches that are controlled by the power controller; determining if the target power value falls within a low, a medium or a high power range, the low power range comprising any power values below a first threshold power value, the medium power range comprising any power values between the first threshold power value and a second threshold power value and the high power range comprising any power values above the second threshold power value; controlling the first group of power switches if the obtained target power value falls within the low power range;
. controlling at least one of the first and the second group of power switches if the obtained target power value falls within the medium power range; and controlling the second group of power switches if the obtained target power value falls within the high power range.

In one or more embodiments the power controller is controlling the power switches of the first and second groups of power switches based on a measurement using a current mirror that is integrated in at least one of the first and second groups of power switches.

In one or more embodiments the target power value is obtained based on a voltage drop across a shunt resistor that is arranged in series with a current path of the power module.

In one or more embodiments the medium power range is further divided into a lower medium power range and a higher medium power range, wherein the lower medium power range comprises any power values between the first threshold power value and an intermediate threshold power value and the higher medium power range comprises power values between the intermediate threshold power value and the second threshold power value. If the obtained target power value falls within the lower medium power range, the method further comprises: controlling the first group of power switches at a time t1 and at a time t2; and controlling the second group of power switches at a time t1+n and at the time t2, or at the time t 1 and at a time t2-n, or at the time t1+n and at the time t2-n; wherein the time t2 is subsequent in time to the time t2-n, the time t2-n is subsequent in time to the time t1+n and the time t1+n is subsequent in time to the time t1, wherein a time offset n may be different or the same for each of the times t1+n and t2-n. If the obtained target power value falls within the higher medium power range, the method further comprises: controlling the first group of power switches at the time t1 and the time t1+n, or at the time t2-n and the time t2, or at each of the times t1, t1+n, t2-n and t2; and controlling the second group of power switches at any time after the time t1 and at any time before the time t2.

According to a fifth aspect of the present disclosure, there is provided a computer program comprising instructions that, when executed by a power controller, causes the power controller to perform a method according to any one of the embodiments herein.

According to a sixth aspect of the present disclosure, there is provided a non-transient machine-readable storage medium comprising instructions that, when executed by a power controller, causes the power controller to: obtain a target power value, the target power value corresponding to an amount of power that is to be supplied by the power module; determine if the target power value falls within a low, a medium or a high power range, the low power range comprising any power values below a first threshold power value, the medium power range comprising any power values between the first threshold power value and a second threshold power value and the high power range comprising any power values above the second threshold power value; control the first group of power switches if the obtained target power value falls within the low power range; control at least one of the first and the second groups of power switches if the obtained target power value falls within the medium power range; control the second group of power switches if the obtained target power value falls within the high power range.

The above discussion is not intended to represent every example embodiment or every implementation within the scope of the current or future claim sets. The figures and detailed description that follow also exemplify various example embodiments. Various example embodiments may be more completely understood in consideration of the following detailed description in connection with the accompanying drawings.

### BRIEF DESCRIPTION OF THE DRAWINGS

The present invention is illustrated by way of example and is not limited by the accompanying figures, in which like references indicate similar elements. Elements in the figures are illustrated for simplicity and clarity and have not necessarily been drawn to scale.
- Fig. 1:: illustrates an example embodiment of a power module comprising a first group of power switches, a second group of power switches and a power controller
- Fig. 2:: illustrates an example embodiment of a power converter comprising one or more power modules, a power source and a load;
- Fig. 3:: illustrates an example embodiment showing different power ranges;
- Fig. 4:: illustrates an example embodiment showing different power ranges;
- Fig. 5:: illustrates an example embodiment showing patterns of operating a first and a second group of power switches;
- Fig. 6:: illustrates an example embodiment showing patterns of operating a first and a second group of power switches;
- Fig. 7:: illustrates an example embodiment showing patterns of operating a first and a second group of power switches;
- Fig. 8:: illustrates an example embodiment showing patterns of operating a first and a second group of power switches;
- Fig. 9:: illustrates an example embodiment of a method performed by a power controller; and
- Fig. 10:: illustrates an example embodiment of a power module.

### DETAILED DESCRIPTION

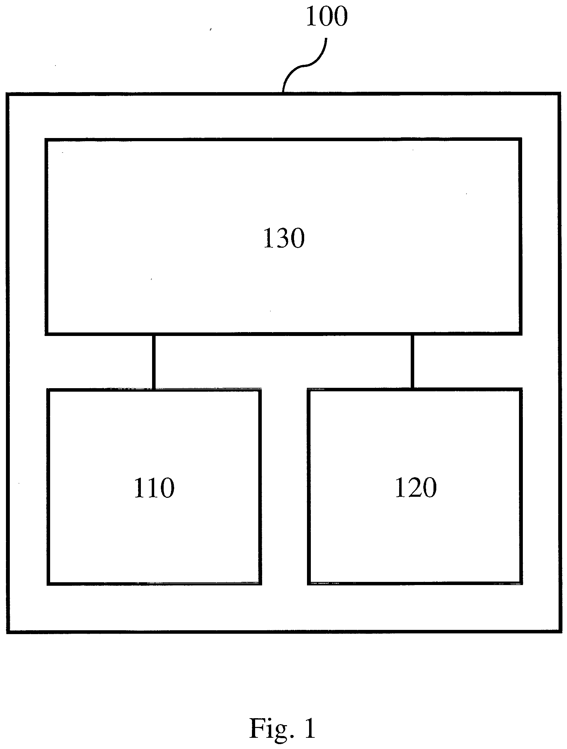

Fig. 1 shows an exemplary power module 100 comprising a first group of power switches 110, a second group of power switches 120 different from the first group of power switches 110, and a power controller 130 electrically connected to the first group and the second group of power switches 110, 120. In this example embodiment, the power controller 130 is configured to control the power switches of the power module 100. Further, the power controller 130 is configured to obtain the target power value, the target power value corresponding to an amount of power that is to be supplied by the power module 100 and to determine whether the target power value falls within a low, a medium or a high power range 140, 150, 160. The low power range 140 comprises power any values below a first threshold power value, the medium power range 150 comprises any power values between the first threshold power value and a second threshold power value and the high power range 160 comprises any power values above the second threshold power value. Accordingly, the second threshold power value is above the first threshold power value. Further, the power controller 130 is configured to control the first group of power switches 110 if the obtained target power value falls within the low power range 140, to control at least one of the first and the second groups of power switches 110, 120 if the obtained target power value falls within the medium power range 150, and to control the second group of power switches 120 if the determined target power value falls within the high power range 160.

In the exemplary embodiment of Fig. 1, the power module 100 is configured in a modular manner such that the module may be used alone or together with a plurality of further such or similar modules.

In the exemplary embodiment of Fig. 1, the term control is used to relate to controlling an electric switch, such as a power switch or a transistor, including any of the first and/or the second groups of power switches 110, 120. Since such switches may be toggled between a turned off state in which they may be non-conductive, a turned on state in which they may be conductive and a floating state, control means that the controller causes the respective switch or switches to assume one of these exemplary states. For example, when the controller controls a power switch, it may switch the power switch to any of a conductive, a non-conductive or a floating state. As an example, a transistor may be controlled by applying a certain voltage to the gate, thereby switching the transistor or setting it to one of these states. For example, a gate driver may be controlled by the power controller 130. The gate driver may then provide a gate voltage to the gate of the various power switches which thereby sets the respective power switch or power switches to any of the exemplary operational states described above. Therefore, the power controller 130 may be used to control at least one or more gate drivers in an autonomous manner such that the power switches 110, 120 may be controlled in a synchronous way. Such synchronized operation allows matching the operation of the power switches 110, 120 with a particular pattern of operation that may be chosen or determined by the power controller 130, as will be described in further detail below. By implementing this control either with the power controller 130, or the gate drivers, or a combination of the power controller 130 and the gate drivers of the power module 100, the power switches 110, 120 may be controlled in an autonomous way. This way the function of the power module 100 may be enhanced through at least one or more of faster reaction to changing and dynamic loads, added safety margins and protection, higher efficiency with lower power losses and increased reliability of operating a hybrid power module architecture using at least two distinct groups of power switches 110, 120. Accordingly, in the exemplary embodiment of Fig. 1, the power switches 110, 120 may refer to switches that may be controlled in such a manner that they supply a certain voltage and current that may be used by the power module to generally supply power or to provide power to a load.

In the exemplary embodiment of Fig. 1, a power controller relates to any one of a circuit element, circuitry, processor, microprocessor, analog circuit or just a part or sub-circuit of any one of these and the like that may perform any steps necessary for operating power switches. The power controller may be conductively connected to said switches and to any other circuit elements, sensors or the like to measure, sense, receive and/or transmit signals or data. Accordingly, the exemplary power controller 130 of Fig. 1 may be any such controller.

The power controller 130 is configured to control the power switches of the power module 100 in such a manner that the power module 100 supplies a target power value. The power controller 130 may obtain the target power value that needs to be supplied, for example by comparing the power that is supplied by the power module 100 with the power which a load that is supplied by the power module 100 is requesting or drawing from the power module 100. It may also determine or ascertain whether this target power value falls within one of three specified power ranges: low, medium, or high. The low power range 140 includes power values below a first threshold power value. The medium power range 150 includes power values between the first and a second threshold power value. Thus, the medium power range 150 comprises higher power values than the low power range 140. The high power range 160 includes power values above the second threshold power value and therefore above both the low power range 140 and the medium power range 150. Just for clarification, it is to be added that the term "between" does not preclude that the respective ends of the interval described, i.e., to the first threshold power value as well as the second threshold power value, need necessarily form part of the medium power range. It may be the case that the medium power value covers any value between the two thresholds as well as the two thresholds themselves. However, one can likewise configure the exemplary power module such that any value up to and including the first threshold power value will lead to the power controller 130 determining or ascertaining that the target power value falls within the low power range 140, any value above the first threshold power value and below the second threshold power value falls within the medium power range, and any value above and including the second threshold power value falls within the high power range. It may also be the case that one of the two power threshold values forms part of the medium power range, while the other forms part of the low or high power range, as applicable.

If the target power value falls within the low power range 140, the power controller 130 controls the first group of power switches 110. For target power values within the medium power range 150, the power controller 130 may control either or both the first and second groups of power switches 110, 120. When the target power value falls within the high power range 160, the power controller 130 controls the second group of power switches 120. In one example, if the target power value falls within the low power range 140, the power controller 130 may be configured to control the first group of power switches 110 by switching the power switches of the first group to a conductive state while switching the power switches of the second group to or keeping the switches of the second group in a non-conductive state. In other words, if the target power value falls within the low power range, the power switches of the first group may be in a conductive state (e.g., switched to a conductive state or be in a conductive state), while the power switches of the second group may be in a non-conductive state (e.g., switched to a non-conductive state or be in a non-conductive state). Additionally, or alternatively, if the target power value falls within the high power range 150, the power controller 130 may be configured to control the second group of power switches 120 by switching the power switches of the second group to a conductive state while switching the power switches of the first group to or keeping the switches of the first group in a non-conductive state. One might also say that in each of the low power range and the high power range the respective group of switches is controlled "exclusively" by the power controller.

Aspects of the power controller 130 of Fig. 1 may allow for an efficient and effective way of controlling and operating different groups of power switches 110 and 120 that leads to reduced energy losses within the power module 100 while maintaining a high degree of safety throughout a large range of different and dynamically changing power ranges even under changing environmental and ambient conditions. The advantages of the configuration of Fig. 1 may further include optimized power management by selectively controlling and operating different groups of power switches based on the required power output. This selective operation may enhance efficiency, reduce wear on individual switches, and potentially extend the lifespan of the power module 100. By categorizing power requirements into low, medium, and high ranges, the power module may more precisely match power supply to demand, which may improve overall performance and reliability.

In one example, the first group of power switches 110 of Fig. 1 may have lower switching losses than the second group of power switches 120. This may be achieved, for example, by selecting relatively small transistors for the first group of power switches 110. Relatively small means, for example, transistors having shorter channel lengths, which reduces the time it takes for charge carriers to travel from the source to the drain. Since the time of switching such transistors between on or off or vice versa may therefore be lower, the control of such transistors may lead to lower energy losses compared with a switching operation that takes longer. This may be particularly advantageous in applications where energy conservation and efficiency are critical. The differentiation in switching losses between the two groups of power switches 110, 120 may allow the power controller 130 to make more informed decisions when determining which group of power switches to control based on the target power value. By controlling the first group of power switches 110 with lower switching losses in low power scenarios, the power module may achieve a more efficient operation, which may reduce unnecessary energy dissipation. Conversely, when higher power values are required, the second group of power switches 120, despite having higher switching losses, may be utilized to meet the demand, ensuring that the power module 100 may handle a wide range of power requirements effectively. Accordingly, the power controller 130 may be capable of leveraging the different switching loss characteristics of the two groups of power switches, which may add a layer of complexity and sophistication to its operation. The ability to selectively control power switches based on their switching losses and the required power range may enhance the adaptability and performance of the power module 100, which may make it more versatile and efficient in various operational contexts. Accordingly, the power module 100 may utilize a hybrid architecture comprising different types of power switches and control them in a manner that may lead to an overall performance improvement of the power module 100.

Further, the first group of power switches 110 of Fig. 1 may have lower conduction losses than the second group of power switches 120. This may also be achieved, for example, by selecting relatively small transistors for the first group of power switches 110, compared with those in the second group. As already described, smaller transistors may have shorter channel lengths, which may also lead to lower internal resistances. This means that less power may be dissipated as heat due to the flow of current through the channel of such transistors. The power controller 130, which may already be configured to obtain the target power value and control the appropriate group of power switches based on the required power range, may therefore have an additional layer of control and optimization. By controlling the first group of power switches 110 if the target power value falls within the low power range 140, the power module 100 may be able to minimize conduction losses, thereby improving overall energy efficiency. This may be particularly advantageous in applications where power consumption needs to be minimized, as it ensures that the power module 100 may operate in the most efficient manner possible at lower power levels.

The first group of power switches 110 of Fig. 1 may further be selected from a metal oxide semiconductor field effect transistor, MOSFET, type. In comparison with, for example, an insulated gate bipolar transistor, IGBT, type, MOSFETs may exhibit a lower on-state voltage drop, faster switching speeds and a higher frequency of operation. Accordingly, when MOSFET type switches are selected for the first group of power switches 110, these switches may allow for a more efficient operation of the power module. If the MOSFET type is also combined with the above-explained aspects of relatively small size, the above-mentioned advantages may be increased even further. For example, if relatively small MOSFETs are used for the first group of power switches 110, they may allow for an even higher degree of efficiency than just choosing the size (relatively small compared with the second group) or type (MOSFET rather than e.g. JFET or BJT) of the switches.

The first group of power switches 110 of Fig. 1 may also be selected from the particular type of MOSFETs that are made using silicon carbide, SiC, and/or gallium nitride, GaN, and may generally be referred to as "wide band-gap" MOSFETs. These types of MOSFETs may operate even more efficiently than standard, i.e. silicon-based, Si, MOSFETs. This may be due to any one or more of the following factors that SiC or GaN MOSFETS may have: lower leakage currents, higher breakdown voltage, higher operating temperature, lower on-state resistance, faster switching speeds. By utilizing SiC and/or GaN MOSFETs, the power module 100 may achieve better thermal management and reduced power losses, thereby enhancing its reliability and operational lifespan. An even higher degree of efficiency may be achieved by combining the aforementioned aspects of small size, MOSFET and SiC and/or GaN. This combination may lead to a highly efficient operation of the power module 100 when operating the first group of power switches 110.

The second group of power switches 120 of Fig. 1 may support a higher maximum supply current than the first group of power switches 110. This may be achieved, for example, by selecting larger transistors compared with those that are selected for the first group of power switches 110. In general, larger transistors have a greater physical area, which may allow them to dissipate more heat, therefore reducing the risk of failure or unsafe operation. Larger transistors may also have more semiconductor material available that may conduct currents. Generally, larger transistors may also have a higher break down voltage due to a thicker oxide layer and generally larger physical dimensions.

The first group of power switches 110 of Fig. 1 may support a faster switching speed than the second group of power switches 120. This may result from selecting relatively larger transistors for the second group of power switches 120 than for the first group of power witches 110. Such slower switching speeds may be particularly advantageous when switching high currents, such as in the high power range 160. This is because a slow switching time results in a slower change of currents. This is often referred to as di/dt, i.e. the rate of change of current over time. If di/dt is rather high, the parasitic values of any real conductors and electric circuits or their elements, i.e. parasitic inductance (L) and capacitance (C), may cause voltage spikes and/or ringing. In other words, the parasitic L and C may form an L-C-circuit that may induce high voltage spikes and a continued oscillation of voltages between the parasitic L and C especially when the rate of change of current over time, i.e. di/dt, becomes too high. Therefore, it may be advantageous to use relatively slow switches when switching rather high amounts of power and therefore currents, because the resulting voltage spikes and oscillations may be kept within safe margins of operation of the electric circuitry. While slower switching may also lead to higher losses, this is a tradeoff that may be worth taking when more efficient and faster switches, such as those that could be used for the first group of power switches 110, would lead to potentially destructive voltage spikes and/or ringing instead. The combination of faster and slower power switches may therefore allow the power module 100 to maintain a high degree of efficiency but also of safe operation by enabling the power controller 130 to control the best-suited power switches depending on the target power value that is to be supplied by the power module 100.

The second group of power switches 120 of Fig. 1 may be of an insulated gate bipolar transistor, IGBT, type. Generally, IGBTs may allow for conducting even higher currents without excessive voltage drops compared with, for example, MOSFETs. Also, they may generally handle relatively higher current densities than MOSFETs. The IGBT type may also be combined with the aforementioned aspect of slower switching speeds and/or larger size to allow an even higher level of improvement of the above-mentioned advantages. Accordingly, when selecting the second group of power switches 120 to be of the IGBT type, this may make them more suitable for the use in the medium and/or higher power ranges 150, 160, depending on the target power value that is to be supplied by the power module 100.

Irrespective from whether large transistors, or transistors of an IGBT type, or transistors having a combination of these two characteristics are used for the second group of power switches 120 as previously described, each of these aspects may enhance the efficiency and reliability of the power module 100 by ensuring that the power switches used for the medium and/or high power ranges 150, 160 are specifically designed to handle increased currents, thereby reducing the risk of overloading and potential failure and increasing safety of operation of the power module 100. Because the power controller 130 may manage the different current capacities of the two groups of power switches 110, 120, it may be able to ensure that the appropriate switches are controlled based on the determined power range. This differentiation in current handling capabilities may lead to improved performance and longevity of the power module 100, as the power switches may be utilized within optimized operating conditions. Additionally, this may contribute to the overall safety and stability of the power module 100 by preventing scenarios where lower capacity switches are subjected to higher currents than they are designed to handle.

Further, in the medium power range 150, the power controller 130 has the flexibility to control either or both groups of power switches 110, 120, leveraging, for example, characteristics such as faster switching speed of the first group of power switches 110 for responsiveness and the slower switching speed of the second group of power switches 120 for handling higher currents if necessary. This may enhance the overall versatility and adaptability of the power module 100, which may allow it to efficiently manage a wide range of power demands while optimizing the performance and longevity of the power switches.

In one example, the power controller is configured to control the power switches of the first and second groups of power switches based on a measurement using a current mirror that is integrated in at least one of the first and second groups of power switches 110, 120. For example, the current supplied by the power module 100 may be measured by the power controller 130 using the current mirror. Current mirrors may provide accurate measurements of the supplied current, because the transistors used for the current mirror may be closely matched with the power switches of at least one of the first and second groups of power switches 110, 120. Further, current mirrors may isolate the measurement circuit from the current path of the power module 100, which may thereby reduce the impact of noise and disturbances. Current mirrors may also be integrated into the power module 100, which may reduce the need for additional or external components.

In one example, the target power value may be obtained by measuring a voltage drop across a shunt resistor that is arranged in series with a current path of the power module 100. In such an example, the separate resistor may be used by the power controller 130 to measure the voltage drop across the resistor. This may allow the power controller 130 to obtain the current. Advantages of using a shunt resistor may include very high accuracy. However, because the resistor is placed directly in the current path of the power module 100, this may also introduce some measurement noise.

Accordingly, a current mirror may be preferred in some applications, for example when integration and isolation are important. A shunt resistor may, however, be preferable for high-accuracy measurements, especially when external components are acceptable. In some cases, a combination of both methods might also be used to achieve the desired level of accuracy and reliability.

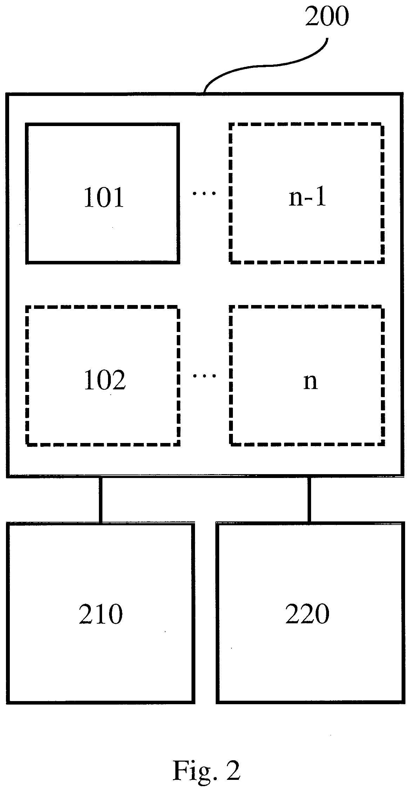

Fig. 2 illustrates an example embodiment in which the power module 100 is used as the single or as one of multiple power modules 101, 102 ... n-1, n within a power converter 200. The optional nature of the power modules is illustrated in Fig. 2 by using dashed lines. The power converter 200 may also have an electric interface, illustrated in Fig. 2 with solid connecting lines. The electric interface may have any suitable form or physical shape and allows for connecting the power converter 200 and its one or more power modules 101, 102 ... n-1, n to a power source 210 and to a load 220. Any of these power modules may be the same as or similar to the power module 100 of Fig. 1. One example of a power source 210 may be a battery. One example of a load 220 may be a vehicle or parts of a vehicle. Accordingly, the power converter 200 may be used for supplying power from a power source 210 to a load 220 at specific target power values, target currents and/or target voltages, wherein the latter may differ significantly from the voltages and/or currents that the power source 210 may directly provide. The modular nature of the power modules may allow the power controller to be adapted such that it is able to handle virtually any power requirements. For example, when the power requirements exceed the capabilities of a single power module 101, using one or more additional power modules allows the power converter 200 to meet the power requirements of the load 220.

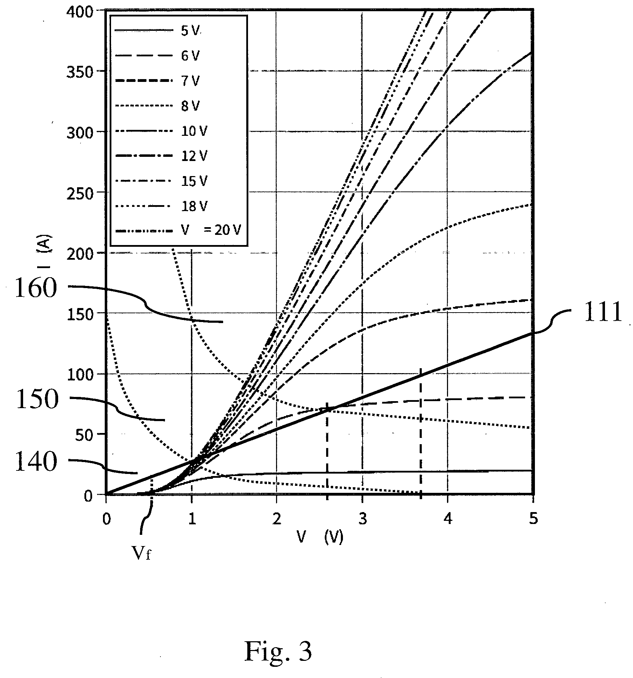

In the exemplary diagram of Fig. 3, different characteristic outputs of exemplary first and second groups of switches 110, 120 are shown. In this diagram, a power range relates to a particular range from a first power value to a second power value, such as from 0 to a first amount of Watts. The boundaries of such a power range may be referred to as threshold power values, such as a first or a second threshold power value. In general, a power range may be defined by a plurality of different combinations of currents or voltages which result in power values within this range (the product of a particular current and voltage value leads to a particular power value). Therefore, in the exemplary diagram, the low power range 140 of Fig. 3 generally corresponds to any power value that is defined by a product of a voltage value and a current value (see the x- and y-axes) being below a first threshold power value. In Fig. 3, an example of the first threshold power value is shown by the curved and dotted line delineating the low power range 140 from the medium power range 150. This is just an example and could deviate according to the specific design chosen for implementing the present disclosure. For example, this line could represent a certain power value such as, e.g., 5, 10, 20, 30, 40 or 50 Watts or any other suitable value. Further, while the illustrated line delineating the low power range 140 from the medium power range 150 in Fig. 3 may not precisely correspond with a single particular power value (products of currents and voltages), especially at the ends near the x- and y-axes, such deviations are possible in light of limitations of a maximum current and/or voltage which the various power switches of the first and/or second groups of power switches may support. However, such deviations are not strictly necessary depending on the particular power switches being used and the respective threshold power value could also align more closely with the particular power value instead. Any combination of these aspects., i.e. alignment and/or slight deviations, may be comprised by the present disclosure. The medium power range 150 and the high power range 160 are defined by respectively higher power values that may be defined by generally higher products of voltages and/or currents. For example, the medium power range 150 corresponds to any power value that is defined by the product of voltage value and current value between the first threshold power value and a second threshold value (e.g., the curved line delineating the medium from the high power range in Fig. 3 which, as already explained above, may also be different and can represent a certain power value, e.g. 100, 200, 300 Watts or other values and may or may not have slight deviations as explained above). The high power range 160 corresponds to any power value above the second threshold value. As such, each of the three power ranges 140, 150 and 160 in Figure 3 corresponds to a certain area within the exemplary voltages-current-diagram of Fig. 3.

Additionally, Fig. 3 shows a first threshold voltage Vf which is the forward voltage of an exemplary second group of power switches 120. Further, the diagonal and solid line 111 of Fig. 3 illustrates an exemplary characteristic output of the first group of power switches 110. For example, the low power range 140 may substantially span the power range within which the exemplary second group of power switches 120 may not be effectively controlled due to their forward voltage. As explained above, this is not necessary and the threshold for the low power range 140 may also deviate therefrom. Therefore, Fig. 3 illustrates an advantage of using two different groups of power switches 110, 120 in the power module 100, since the different characteristics of the chosen power switches may be selected such that they allow for an efficient operation of the power module 100 even within the low power range 140. While the forward voltage Vf is chosen as an illustrative value in this example, any other characteristics or values may be selected instead of this voltage for definition of the low power range 140.

The medium power range 150 in the example of Fig. 3 substantially spans the power range within which the switches of either the first or the second groups of power switches 110, 120 may be controlled or operated. This adds to the flexibility of how the power control 130 of the power module 110 may control the power switches within the medium power range 150.

The high power range 160 in the example of Fig. 3 substantially spans the power range within which the switches of the second group of power switches 120 may be controlled or operated. As should be illustrated by the example output characteristic 111 of the first group of power switches, the maximum amount of power these switches may be able to supply may be exceeded by the high power range 160.

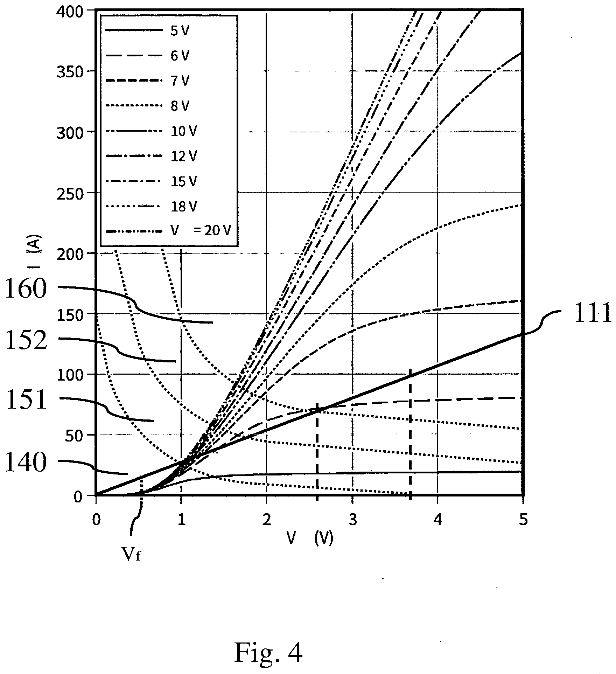

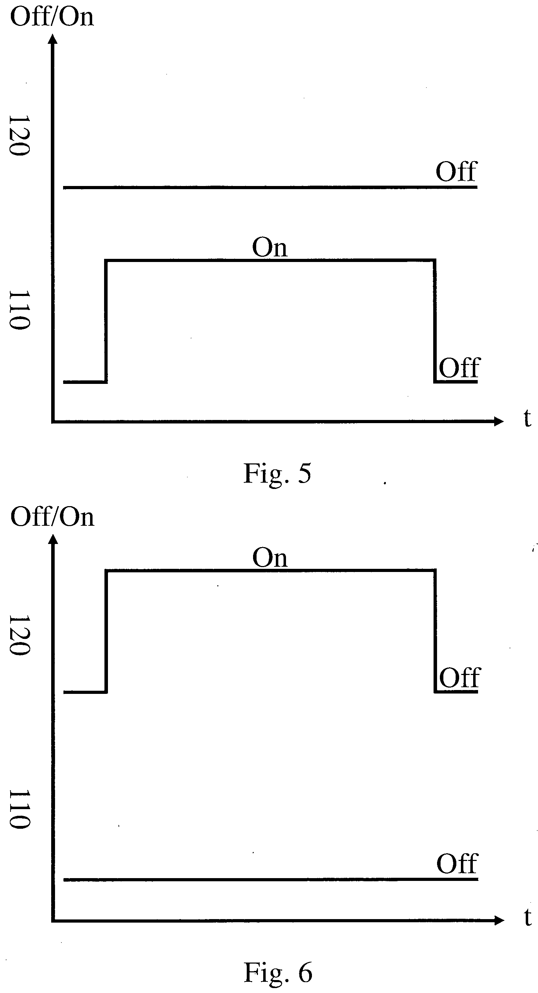

In the exemplary embodiment of Fig. 4, another set of exemplary power ranges is shown. In this example, the medium power range 150 of Fig. 3 is further divided into a lower medium power range 151 and a higher medium power range 152, wherein the lower medium power range 151 comprises power values between the first threshold power value and an intermediate threshold power value and the higher medium power range 152 comprises power values between the intermediate threshold power value and the second threshold power value. In this example, the power controller 130 may be configured to control the first group and the second group of power switches 110, 120 during different times throughout a period of time when the determined target power value falls within the lower medium or the higher medium power range 151, 152. While Fig. 4 is similar to Fig. 3 such that the description regarding Fig. 3 above similarly applies to Fig. 4, it differs in that the medium power range 150 is represented by a lower medium power range 151 and a higher medium power range 152. Like the thresholds in Fig. 3, the threshold illustrated by the curved and dotted line between these power ranges in Fig. 4 may also deviate and/or be selected differently from the illustrated one. This additional distinction adds a level of granularity for how the power controller 130 may control the first and/or the second groups of power switches 110, 120. Particularly, if the first group of power switches 110 is optimized for operation at lower power values and if it may not be able to safely handle prolonged durations of time of supplying higher power values, it may be advantageous to further distinguish in how long and when the different groups of power switches are operated throughout the different power levels that fall within the medium power range 150 of Fig. 3. By differentiating between the lower and higher medium power ranges 151 and 152 as illustrated in Fig. 4, the power controller 130 may be able to use one of several patterns of operating the different groups of power switches to further enhance the efficiency and safety of operation of the power module 100, as will be explained in further detail with respect to Figures 5 to 8 below.

If the power controller 130 is configured to control the first group and the second group of power switches 110, 120 during different times throughout a period of time when the determined target power value falls within either the lower medium or the higher medium power range, it is able to manage power distribution in a more specific manner, which may enhance the efficiency and responsiveness of the power module 100. By dividing the medium power range into two sub-ranges, the power controller 130 may optimize the operation of the power switches to better match the specific power requirements, potentially reducing degradation of the switches and improving overall performance of the power module 100.

Fig. 5 illustrates an example embodiment showing patterns of controlling a first and a second group of power switches 110, 120. Particularly, Fig. 5 shows exemplary operational states of the first group of power switches 110 and the second group of power switches 120 over time t. The vertical axis represents the on/off states of the power switches 110, 120, while the horizontal axis represents time. Initially, the first group of power switches 110 is in the off state. As time progresses, the first group of power switches 110 transitions to the on state, remains on for a period, and then transitions back to the off state. Throughout this period, the second group of power switches 120 remains in the off state. During this time interval, only the first group of power switches 110 is active, while the second group of power switches 120 is inactive. Accordingly, Fig. 5 shows a pattern that the power controller 130 may use when the determined target power value falls within the low power range 140.

Fig. 6 illustrates an example embodiment showing patterns of controlling a first and a second group of power switches 110, 120. Particularly, Fig. 6 shows a different operational scenario for the first group of power switches 110 and the second group of power switches 120 over time t. Initially, the first group of power switches 110 is in the off state, and the second group of power switches 120 is also in the off state. As time progresses, the second group of power switches 120 transitions to the on state, remains on for a period, and then transitions back to the off state. Throughout this period, the first group of power switches 110 remains in the off state. During this time interval, only the second group of power switches 120 is active, while the first group of power switches 110 is inactive. Accordingly, Fig. 6 shows a pattern that the power controller 130 may use when the determined target power value falls within the high power range 160.

In summary, Figs. 5 and 6 depict distinct examples of operational periods of the first group of power switches 110 and the second group of power switches 120. Figure 5 shows the exemplary operation of the first group of power switches 110, while Figure 6 shows the exemplary operation of the second group of power switches 120. The respective operation of the first and second groups of power switches 110, 120 may therefore be exclusive if the target power value falls within the low power range 140 or the high power range 160. These figures illustrate the capability of the power controller 130 to selectively control different groups of power switches based on the target power value and the corresponding power range. Even though Figs. 5 and 6 illustrate an off state as the state of the power switches before and after t1 and/or t2, the described patterns may be used with any possible combination of such initial or end states and is not limited to being off as is illustrated in these figures.

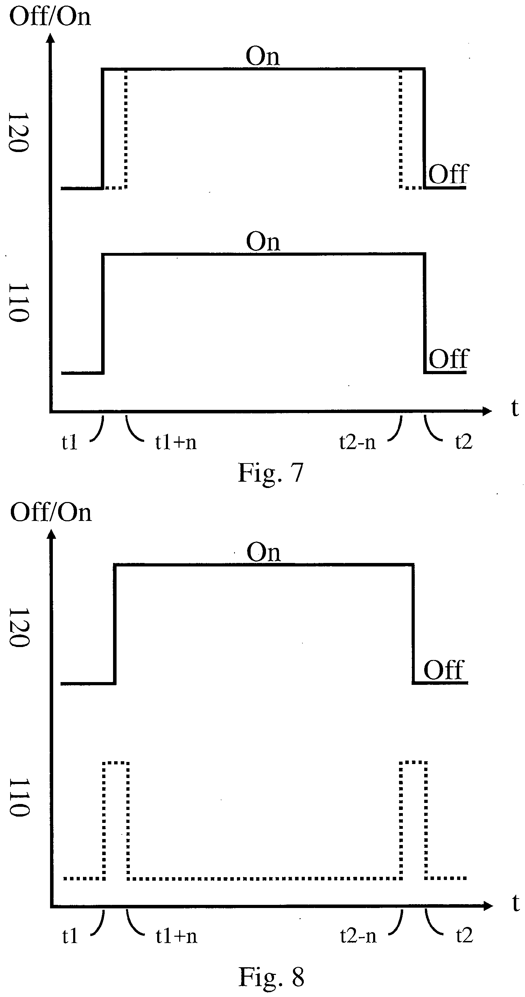

Fig. 7 illustrates an example embodiment showing patterns of controlling a first and a second group of power switches 110, 120. Particularly, Fig. 7 illustrates the operational timing sequence of the first group of power switches 110 and the second group of power switches 120 in a power module 100. The x-axis represents time t, while the y-axis indicates the on/off state of the power switches. The timing sequence has the following distinct times that split the total duration into separate periods: t1, t1+n, t2-n, and t2. These particular times are chosen for the sake of illustration and may be chosen differently from the illustrated example in Fig. 7. Also, while time t1+n and time t2-n refer to the same time offset "n", neither of both offset values "n" is fixed or must be identical to one another, but they may also be fixed, i.e. the same. The respective times may be chosen to suit the needs of the electric circuit design. For example, the time offset "n" may be in the range of nanoseconds to microseconds, such as in between 50 nanoseconds to 1 microseconds, or 50 to 100 nanoseconds, or 50 to 500 microseconds, or 100 to 500 microseconds, or 500 nanoseconds to 1 microsecond, or 1 microsecond to 2 microseconds.

Before time t1, both the first group of power switches 110 and the second group of power switches 120 are initially in the off state. At time t1, the first group of power switches 110 transitions to the on state and remains on until time t2. Concurrently, the second group of power switches 120 transitions to the on state at either time t1 as well, or at time t1+n instead, as indicated by the dotted lines. The second group of power switches 120 turns off either at time t2-n, as indicated by the dotted lines, or at time t2 instead. At time t2, both groups of power switches 110 and 120 have returned to the off state.

Accordingly, Fig. 7 illustrates an example embodiment where the power controller 130 is configured to control the first group of power switches 110 (by switching, the power switches of the first group to a conductive state) from a beginning (t1) to an end (t2) of the period of time during which the determined target power value may fall within the lower medium power range 151. In this lower power range of the medium power range 150, the switches of the first group of power switches 110 may operate sufficiently well to allow them to supply power throughout the entire period of time (t1 to t2) during which the determined target power value falls within this range. Further, power controller 130 may be configured to control the second group of power switches 120 from the beginning (t1) to the end (t2) of said period of time, or from shortly after the beginning (t1+n) to the end (t2) of said period of time, or from the beginning (t1) to shortly before the end (t2-n) of said period of time, or from shortly after the beginning (t1+n) to shortly before the end (t2-n) of said period of time (by switching the power switches of the second group to a conductive state). By controlling the second group of power switches 120 such that they turn on and/or off at the same times as the first group of power switches 110, the power controller 130 may share the workload of supplying the target power value among all power switches of the power module 100.

In a case where the second group of power switches 120 switches slower than the first group of power switches 110, the first group of power switches 110 may switch and therefore supply a larger part of the target power first even if both groups are controlled at the same time. This may result in the advantage that the first group of power switches 110 handles a majority of the power during a period of time when switching losses could lead to decreased efficiency or increased losses within the power module 100. Accordingly, this pattern may allow for an increase of the efficiency of the power module 100. This advantage may be further enhanced by the power controller 130 switching the second group of power switches 120 on later than the first group of power switches 110, for example at time t1+n, as is illustrated by the dotted lines in Fig. 7.

This may also be referred to as a soft turn on operation. The same applies when switching the power switches off again, with the difference being that the second group of power switches 120 are then turned off before the first group of power switches 110. This may also be referred to as a soft turn off operation. Accordingly, when the second group of power switches 120 is turned off before the first group of power switches 110 at time t2-n, the switching losses may be advantageously reduced. As a result, the various patterns of controlling the two groups of power switches may allow the power controller 130 to increase the efficiency of the power module 100 when the target power value falls within the lower medium power ranger 151.

Fig. 8 illustrates an example embodiment showing patterns of controlling a first and a second group of power switches 110, 120. Particularly, Fig. 8 depicts an alternative timing sequence for the first group of power switches 110 and the second group of power switches 120. Similar to Figure 7, the x-axis represents time t, and the y-axis indicates the on/off state of the power switches. The timing sequence is divided into the same periods with times t1, t1+n, t2-n, and t2. These particular times are chosen for the sake of illustration and may be chosen differently from the illustrated example in Fig. 7. Also, while time t1+n and time t2-n refer to the same time offset "n", neither of both offset values "n" is fixed or must be identical to one another, but they may also be fixed, i.e. the same. The respective times may be chosen to suit the needs of the electric circuit design.

Before time t1, both groups of power switches 110 and 120 are initially off. At time t1, the first group of power switches 110 may transition to the on state and then remains on until time t1+n. The second group of power switches 120 transitions to the on state with an additional time delay between time t1 and time t1+n. The second group of power switches 120 then remains on until another additional time delay after time t2-n, i.e. sometime between time t2-n and time t2. Before this transition of the second group of power switches 120, the first group of power switches 110 may turn on at time t2-n and then remains on until time t2.

Accordingly, Fig. 8 illustrates and example embodiment where the power controller 130 is configured to control the first group of power switches 110 from a beginning (t1) to shortly after the beginning (t1+n) of a period of time during which the determined target power value falls within the higher medium power range 152, or from shortly before an end (t2-n) to the end (t2) of said period of time, or both from the beginning (t1) to shortly after the beginning (t1+n) and from shortly before the end (t2-n) to the end (t2) of said period of time. Further, power controller 130 is configured to control the second group of power switches 120 for another period of time that falls within the period of time during which the determined target power value falls within the higher medium power range 152. This particular pattern of operating the power switches of the power module 100 may allow for the advantage of reducing switching losses while maintaining safety of operation of the power module 100. This is because the relatively higher power target values within the higher medium power range 152 may exceed a level of power that the first group of power switches 110 are able to safely and efficiently maintain for prolonged amounts of time. Accordingly, different from the example of Fig. 7, the first group of power switches 110 may not be controlled over the entirety of this duration. However, because operation of these switches for relatively short periods is still possible at such power levels, the power controller 130 may leverage the first group of power switches for softly turning on or off the second group of power switches 120 which may have higher switching losses. Therefore, the power module 100 may benefit from reduced switching losses when first turning on or last turning off the power switches of the first group of power switches 110, while still allowing for a higher total power output that the second group of power switches 120 may be able to sustain in a safe manner. It is also possible for the power controller 130 to perform just the soft turn on, just the soft turn off, or both a soft turn on and soft turn off when the obtained target power value falls withing the higher medium power range 152.

Even though Figs. 7 and 8 illustrate an off state as the state of the power switches before and after t1 and t2, the described patterns may be used with any possible combination of such initial or end states and is not limited to being off as is illustrated in these figures.

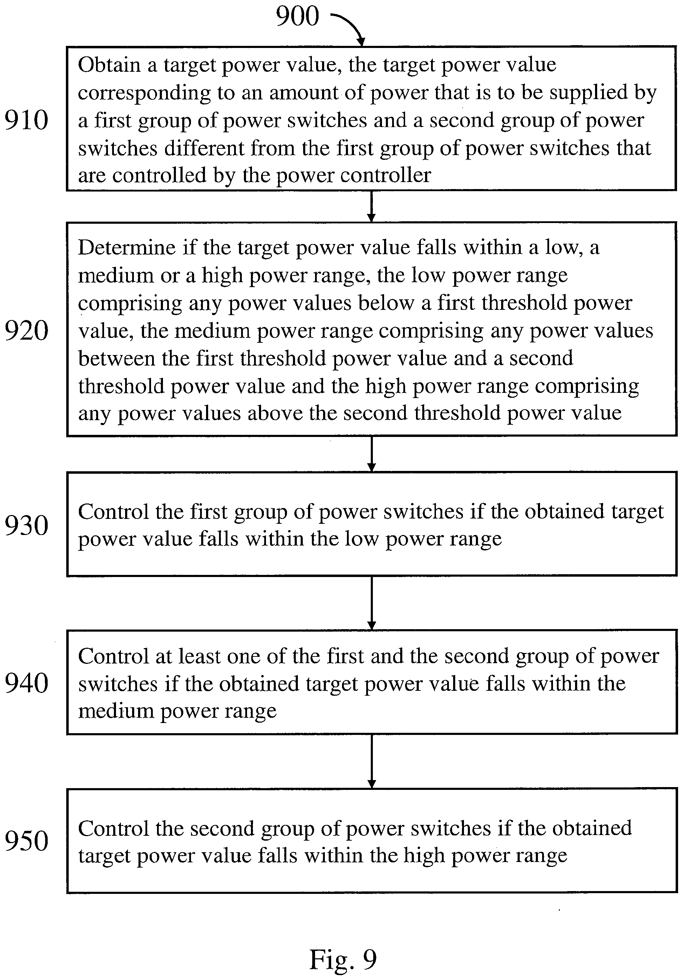

Fig. 9 illustrates an exemplary embodiment in a flowchart that shows a method 900 performed by a power controller for managing the operation of different groups of power switches based on a target power value. The method 900 may be performed by any of the devices of the present example embodiments, such as power module 100, power converter 200 and the like. The method may begin at step 910, where the power controller obtains a target power value, the target power value corresponding to an amount of power that is to be supplied by a first group of power switches and a second group of power switches different from the first group of power switches that are controlled by the power controller.

Proceeding to step 920, the power controller determines if the target power value falls within a low, medium, or high power range. The low power range comprises any power values below a first threshold power value. The medium power range comprises any power values between the first threshold power value and a second threshold power value. The high power range comprises any power values above the second threshold power value.

At step 930, the power controller controls the first group of power switches if the obtained target power value falls within the low power range.

In step 940, the power controller controls at least one of the first and the second group of power switches if the obtained target power value falls within the medium power range.

Finally, at step 950, the power controller the second group of power switches if the obtained target power value falls within the high power range.

The method 900 provides a systematic approach for the power controller to manage power distribution effectively by engaging the appropriate group of power switches based on the target power value. The method ensures optimized performance and efficiency by leveraging characteristics of different power switches for varying power demands.

The instructions and/or flowchart steps in Fig. 9 may be executed in any order, unless a specific order is explicitly stated. Also, those skilled in the art will recognize that while one example set of instructions/method has been discussed, the material in this specification may be combined in a variety of ways to yield other examples as well, and are to be understood within a context provided by this detailed description.

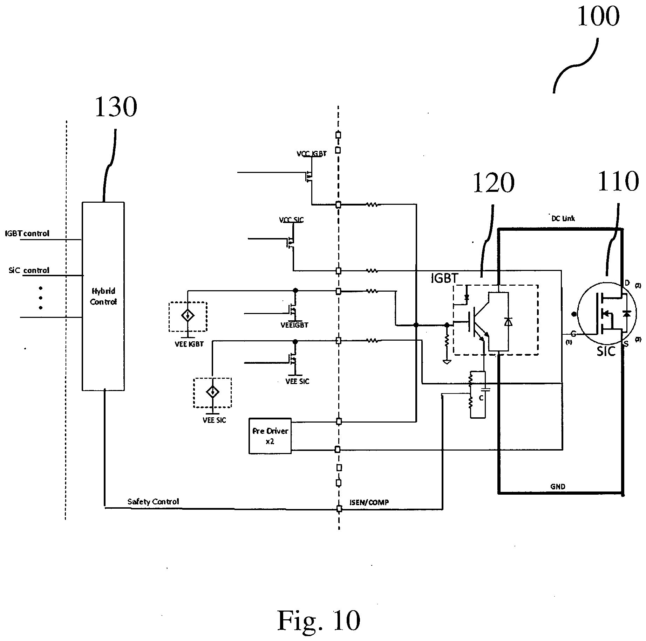

Fig. 10 illustrates an exemplary embodiment of a power module 100 in an illustrative circuit diagram layout. Other electrical connections and layouts are possible in addition to the illustrative layout or instead of this illustrative layout. For example, the first group of power switches is illustrated with the SiC transistor 110 and may be implemented using any number of power switches of any type as previously explained. Further, the second group of power witches 120 is illustrated by the IGBT transistor 120 and may similarly be implemented using any number of power switches of any type as previously explained. The power controller 130 may be implemented using any circuit element or combination of circuit elements. The power controller 130 may have any number of inputs and outputs via which it may control, for example, the power switches of the first and second groups of power switches 110, 120. This is illustrated in Fig. 10 via the dots next to the power control 130.

For example, one input/output may be conductively connected to control lines leading to the gates of the transistors of the first and second groups of power switches 110, 120 to enable the power controller 130 to control the state of these switches as previously described. Other input/output lines may be used, for example, to set up the power controller 130 and configure its use. For example, the power controller 130 may be configured by setting up or changing various power threshold values to define the different power ranges as previously described, such as at least one or more of the low, medium, lower medium, higher medium or high power range. Additionally, or alternatively, it may be configured to set up or change the power threshold values in between the respective power ranges as previously described. Additionally, or alternatively, it may be configured to set up or change the timing of control of at least one of the first and the second groups of power switches 110, 120 as previously described.

Additionally, or alternatively, the power control 130 may be configured to measure or obtain at least one or more of a voltage and a current of the circuit elements of the power module 100. The power controller 130 may base decisions for controlling the first and second groups of power switches 110, 120 on such measured or obtained values. Accordingly, the power control 130 may use the illustrated inputs/outputs and connections of Fig. 10 to enable it to be configured accordingly and to control any of the circuit elements of the power module 100. Further, the power control 130 may have one or more inputs/outputs and connections in addition to those illustrated in Fig. 10 for such or similar purposes.

In some example embodiments the set of instructions/method steps described above are implemented as functional and software instructions embodied as a set of executable instructions which are effected on a computer or machine which is programmed with and controlled by said executable instructions. Such instructions are loaded for execution on a processor (such as one or more CPUs). The term processor includes microprocessors, microcontrollers, processor modules or subsystems (including one or more microprocessors or microcontrollers), or other control or computing devices. A processor may refer to a single component or to plural components.

In other examples, the set of instructions/methods illustrated herein and data and instructions associated therewith are stored in respective storage devices, which are implemented as one or more non-transient machine or computer-readable or computer-usable storage media or mediums. Such computer-readable or computer-usable storage medium or media is (are) considered to be part of an article (or article of manufacture). An article or article of manufacture may refer to any manufactured single component or multiple components. The non-transient machine or computer-usable media or mediums as defined herein excludes signals, but such media or mediums may be capable of receiving and processing information from signals and/or other transient mediums.

Example embodiments of the material discussed in this specification may be implemented in whole or in part through network, computer, or data based devices and/or services. These may include cloud, internet, intranet, mobile, desktop, processor, look-up table, microcontroller, consumer equipment, infrastructure, or other enabling devices and services.

In this specification, example embodiments have been presented in terms of a selected set of details. However, a person of ordinary skill in the art would understand that many other example embodiments may be practiced which include a different selected set of these details. It is intended that the following claims cover all possible example embodiments.

### LIST OF REFERENCE SIGNS

- 100: Power module
- 101: First power module
- 102: Second power module
- n-1: Power module n-1
- n: Power module n
- 110: First group of power switches
- 111: Characteristic output of the first group of power switches
- 120: Second group of power switches
- 130: Power controller
- 140: Low power range
- 150: Medium power range
- 151: Lower medium power range
- 152: Higher medium power range
- 160: High power range
- V_{f}: Forward voltage of the second group of power switches
- t: Time
- t1: First moment in time
- t1+n: Moment in time shortly after the first moment in time
- t2: Second moment in time
- t2-n: Moment in time shortly before the second moment in time
- 200: Power converter
- 210: Power source
- 220: Load

## Claims

1. A power module comprising:
a first group of power switches;
a second group of power switches different from the first group of power switches; and
a power controller electrically connected to the first group and the second group of power switches, wherein the power controller is configured to control the power switches of the power module, and wherein the power controller is further configured to:
obtain a target power value, the target power value corresponding to an amount of power that is to be supplied by the power module;
determine if the target power value falls within a low, a medium or a high power range, the low power range comprising any power values below a first threshold power value, the medium power range comprising any power values between the first threshold power value and a second threshold power value and the high power range comprising any power values above the second threshold power value;
control the first group of power switches if the obtained target power value falls within the low power range;
control at least one of the first and the second groups of power switches if the obtained target power value falls within the medium power range;
control the second group of power switches if the obtained target power value falls within the high power range.

2. The power module of claim 1, wherein the first group of power switches has lower switching losses than the second group of power switches.

3. The power module of any one of claims 1 or 2, wherein the first group of power switches has lower conduction losses than the second group of power switches if supplying power at levels within the low power range.

4. The power module of any one of claims 1 to 3, the first group of power switches being one of a silicon carbide, SiC, metal oxide semiconductor field effect transistor, MOSFET or a gallium nitride, GaN, MOSFET.

5. The power module of any one of claims 1 to 4, wherein the power switches of the second group of power switches support a higher maximum output current than the power switches of the first group of power switches.

6. The power module of any one of claims 1 to 5, wherein the power switches of the first group of power switches support a faster switching speed than the power switches of the second group of power switches.

7. The power module of any one of claims 1 to 6, wherein the second group of power switches is of an insulated gate bipolar transistor, IGBT, type.

8. The power module of any one of claims 1 to 7, wherein the medium power range is further divided into a lower medium power range and a higher medium power range, wherein the lower medium power range comprises any power values between the first threshold power value and an intermediate threshold power value and the higher medium power range comprises power values between the intermediate threshold power value and the second threshold power value; and wherein the power controller is further configured to control the first group of power switches at times that at least partially differ from times during which the second group of power switches are controlled by the power controller, if the obtained target power value falls within the lower medium or the higher medium power range.

9. The power module of claim 8, wherein, if the obtained target power value falls within the lower medium power range, the power controller is further configured to:
control the first group of power switches at a time t1 and at a time t2; and
control the second group of power switches at a time t1+n and at the time t2, or at the time t1 and at a time t2-n, or at the time t1+n and at the time t2-n;
wherein the time t2 is subsequent in time to the time t2-n, the time t2-n is subsequent in time to the time t1+n and the time t1+n is subsequent in time to the time t1, wherein a time offset n may be different or the same for each of the times t1+n and t2-n.

10. The power module of any one of claims 8 or 9, wherein, if the obtained target power value falls within the higher medium power range, the power controller is further configured to:
control the first group of power switches at the time t1 and the time t1+n, or at the time t2-n and the time t2, or at each of the times t1, t1+n, t2-n and t2; and
control the second group of power switches at any time after the time t1 and at any time before the time t2.

11. The power module of any one of claims 1 to 10, wherein the power controller is configured to control the power switches of the first and second groups of power switches based on a measurement using a current mirror that is integrated in at least one of the first and second groups of power switches.

12. The power module of any one of claims 1 to 10, wherein the power controller is configured to obtain the target power value based on a voltage drop across a shunt resistor that is arranged in series with a current path of the power module.

13. A power converter comprising: one or more power modules according to any of the preceding claims and an electric interface configured for connecting the power converter to a power source and to a load.

14. A method performed by a power controller comprising:
obtaining a target power value, the target power value corresponding to an amount of power that is to be supplied by a first group of power switches and a second group of power switches different from the first group of power switches that are controlled by the power controller;
determining if the target power value falls within a low, a medium or a high power range, the low power range comprising any power values below a first threshold power value, the medium power range comprising any power values between the first threshold power value and a second threshold power value and
the high power range comprising any power values above the second threshold power value;
controlling the first group of power switches if the obtained target power value falls within the low power range;
controlling at least one of the first and the second group of power switches if the obtained target power value falls within the medium power range; and
controlling the second group of power switches if the obtained target power value falls within the high power range.

15. A computer program comprising instructions that, when executed by a power controller, causes the power controller to perform a method according to claim 14.
